# EUROPEAN PATENT APPLICATION

(11) **EP 2 355 233 A1**
(43) Date of publication of application: **10.08.2011**
(21) Application number: 09826103.5
(22) Date of filing: 11.11.2009
(51) Int. Cl.: H01M 14/00, H01L 31/04

(54) **PHOTOCHEMICAL CELL COMPRISING SEMICONDUCTOR MICROPARTICLES SENSITIZED WITH BINUCLEAR METAL COMPLEX DYE AND ELECTROLYSIS SOLUTION MAINLY COMPOSED OF IONIC LIQUID**

(30) Priority: 12.11.2008 JP 2008289321; 15.10.2009 JP 2009238047
(71) Applicant: Ube Industries, Ltd., Ube-shi, Yamaguchi-ken 755-8633 (JP)
(72) Inventor: AOKI, Soh, Ichihara-shi Chiba 290-0045 (JP); IWASA, Takafumi, Ichihara-shi Chiba 290-0045 (JP); KAKUTA, Yoshihisa, Tokyo 105-8449 (JP)
(74) Representative: Cabinet Plasseraud
(86) International application number: PCT/JP2009/069204
(87) International publication number: WO 2010/055856

(57) **Abstract**

The photochemical cell of the present invention comprises a semiconductor particle sensitized with a binuclear metal complex dye, which has a high absorption coefficient and an excellent electron transfer property, and an electrolyte solution comprising an ionic liquid as the major component. The photochemical cell is superior in durability.

## Description

### Technical Field

The present invention relates to a photochemical cell, which comprises a photoelectric conversion element comprising a semiconductor particle sensitized with a binuclear ruthenium complex dye or a ruthenium-osmium complex dye, which has a high absorption coefficient and an excellent electron transfer property, and an electrolyte solution comprising an ionic liquid as the major component.

### Background Art

A solar cell is greatly expected to serve as a clean renewable energy source, and researches have been conducted for practical application of a monocrystalline -silicon-, polycrystalline - silicon - or amorphous-silicon-based solar cell and a solar cell comprising a compound such as cadmium telluride and indium copper selenide. For the spread of solar cell as a household power source, however, any of these cells faces many problems to be overcome, including a higher production cost, difficulty in ensuring raw materials, difficulty in recycling, and difficulty in realizing a larger area. Accordingly, there have been proposed solar cells comprising an organic material in an attempt to achieve a larger area and a lower cost. However, any of these cells has a photoelectric conversion efficiency of about 1 %, which falls very short of practical use.

Under such circumstances, Graetzel et al. disclosed a photoelectric conversion element and a solar cell which comprises semiconductor particles sensitized with a dye, as well as materials and production technique needed to produce this solar cell (see, for example, Non-patent document 1 and Patent document 1). This solar cell is a wet solar cell comprising a porous titania thin film sensitized with a ruthenium dye as a working electrode. This solar cell has the advantages that the photoelectric conversion element can be provided at a lower cost because inexpensive materials can be used without highly purification, and that the solar cell can convert solar light into electricity over a wide visible light wavelength range because a dye having broad absorption band is used. However, the photoelectric conversion efficiency must be further improved for practical use. Thus, there is still a need for a dye which has a higher absorption coefficient and absorb light of longer wavelength.

Meanwhile, to cite one example of an electrolyte composition comprising an ionic liquid, Patent document 2 discloses an electrolyte composition comprising an ionic liquid and a copper complex which is dissolved in the ionic liquid; a photoelectric conversion element comprising the electrolyte composition; and a dye-sensitized solar cell comprising the same. However, the dye-sensitized solar cell may not exhibit high photoelectric conversion efficiency.

In addition, Patent document 3, which is a patent application of the applicant, discloses a binuclear metal complex dye such as a binuclear ruthenium complex dye, which is superior in that a photochemical cell comprising the dye exhibits high photoelectric conversion efficiency. However, Patent document 3 does not teach a photoelectric conversion element comprising an ionic liquid as an electrolyte solution in combination with a semiconductor particle sensitized with the binuclear metal complex dye. Thus, there is a need for a study of an ideal combination of the binuclear metal complex dye and an ionic liquid, leading to improvements in photoelectric conversion efficiency and durability of photochemical cells.

### Citation List

### Patent Document

Patent document 1: JP-A-1989-220380
Patent document 2: JP-A-2006-107771
Patent document 3: WO 2006/038587 A1
Non-Patent Document
Non-patent document 1: Nature, Vol.353, p.737, 1991

### Summary of Invention

### Problems to be Solved by the Invention

An object of the present invention is to provide a photochemical cell having good durability, which comprises a semiconductor particle sensitized with a binuclear ruthenium complex dye or a ruthenium-osmium complex dye, which has a high absorption coefficient and an excellent electron transfer property, and an electrolyte solution comprising an ionic liquid as the major component.

### Means for Solving the Problems

The present invention relates to a photochemical cell, comprising:
a semiconductor particle sensitized with a binuclear metal complex dye, which is represented by the following general formula (1):

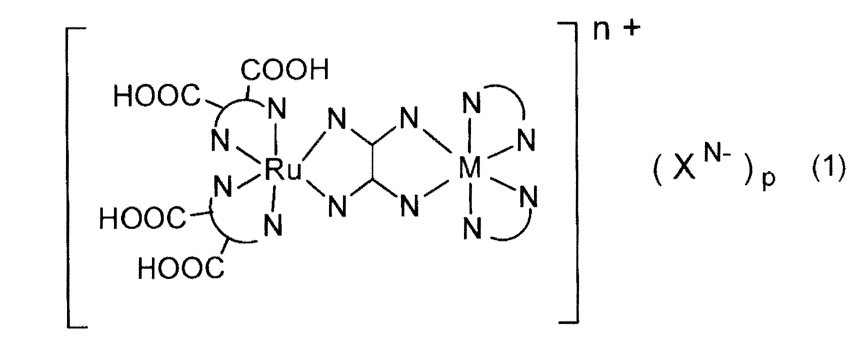

wherein
M represents Ru or Os,
X^{N-} represents an N-valent anion as a counter ion, wherein N is 1 or 2,

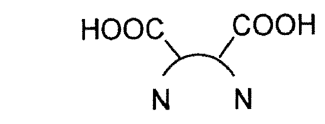

represents a bidentate nitrogen-containing ligand having two carboxyl groups,

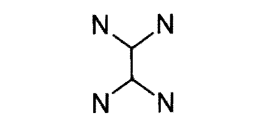

represents a tetradentate nitrogen-containing ligand,

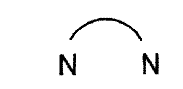

represents a bidentate nitrogen-centaining ligand, n represents an integer of from 0 to 2,
p represents a number of the counter ions needed to neutralize a charge of the complex, and
one or more carboxyl groups (-COOH) may be deprotonated to be a carboxyl ion (-COO⁻); and
an electrolyte solution which comprises an ionic liquid containing (CN)₄B⁻ as an anion component, wherein the ionic liquid is the major component of the electrolyte solution.

### Effect of the Invention

According to the present invention, there may be provided a photochemical cell having high photoelectric conversion efficiency and good durability, which comprises a semiconductor particle sensitized with a binuclear metal complex dye (binuclear ruthenium complex dye or ruthenium-osmium complex dye) which has a high absorption coefficient and an excellent electron transfer property, and an electrolyte solution comprising an ionic liquid as the major component. A photochemical cell comprising an ionic liquid as the major component of the electrolyte solution generally has high stability and high durability. Among others, however, the photochemical cell of the present invention may have remarkably high durability.

The electrolyte solution may preferably comprise an ionic liquid and a redox couple. In that case, the ionic liquid is used as a solvent.

The photochemical cell may have high photoelectric conversion efficiency, and remarkably high stability and durability; therefore the photochemical cell is expected to be fit for practical use.

### Brief Description of the Drawing

FIG. 1 is a graph showing the durability test results for photochemical cells produced in Example 1 and Comparative Examples 1 to 6.
FIG. 2 is a graph showing the durability test results for photochemical cells produced in Examples 2 and 3.

### Description of Embodiments

According to the present invention, the semiconductor particle sensitized with the binuclear metal complex dye may be prepared by bringing a semiconductor particle into contact with the binuclear ruthenium complex or the ruthenium-osmium complex.

The binuclear ruthenium complex or the ruthenium-osmium complex to be used in the present invention is represented by the general formula (1) as described above.

In the general formula (1), M represents Ru or Os, preferably Ru.

X^{N-} represents an N-valent anion as a counter ion, wherein N is 1 or 2. X⁻ may be, for example, hexafluorophosphate ion, perchlorate ion, tetraphenylborate ion, tetrafluoroborate ion, trifluoromethanesulfonate ion, thiocyanate ion, sulfate ion, nitrate ion, or halide ion such as chloride ion and iodide ion. X⁻ may be preferably hexafluorophosphate ion, tetrafluoroborate ion, nitrate ion or halide ion, more preferably hexafluorophosphate ion, tetrafluoroborate ion, nitrate ion or iodide ion. X²⁻ may be, for example, sulfate ion, sulfite ion, thiosulfate ion, carbonate ion, or monohydrogen phosphate ion. X²⁻ may be preferably sulfate ion.

And,

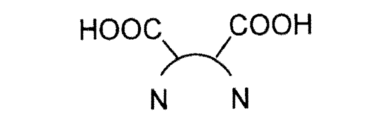

represents a bidentate nitrogen-containing ligand having two carboxyl groups. One or more carboxyl groups (-COOH) may be deprotonated to be a carboxyl ion (-COO⁻). The complex contains two bidentate nitrogen-containing ligands having two carboxyl groups. These two ligands may be the same, or may be different from each other.

The bidentate nitrogen-containing ligand having two carboxyl groups may be, for example, a ligand represented by the following formula (1-A):

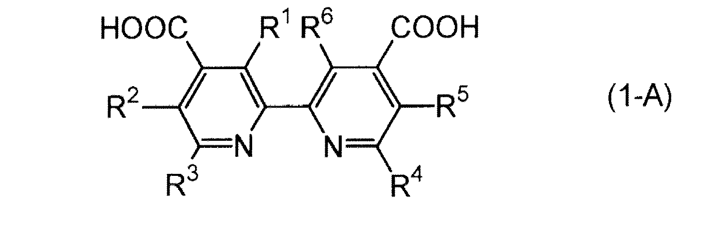

In the formula (1-A), proton(s) (H⁺) of one or more carboxyl groups (-COOH) may dissociate. R¹, R², R³, R⁴, R⁵ and R⁶ each independently represents hydrogen, or a substituted or unsubstituted linear or branched alkyl group, or alternatively, two or more of R¹ to R⁶ form a substituted or unsubstituted aromatic hydrocarbon ring together with the carbon atoms to which they are bound.

The alkyl group may preferably have up to 6 carbon atoms. The alkyl group may be more preferably methyl or ethyl.

It is also preferred that R² and R³, and/or R⁴ and R⁵, and/or R¹ and R⁶ form a six-membered aromatic hydrocarbon ring, which may optionally have a substituent, together with the carbon atoms to which they are bound. Examples of the substituent on the aromatic hydrocarbon ring include alkyl groups such as methyl and ethyl, and alkoxy groups such as methoxy and ethoxy.

It is particularly preferred that R¹ to R⁶ are all hydrogen. It is also particularly preferred that R¹ and R⁶ are hydrogen, and R² and R³, and R⁴ and R⁵ form a six-membered aromatic hydrocarbon ring together with the carbon atoms to which they are bound. It is further preferred that R¹ to R⁶ are all hydrogen.

The bidentate nitragen-containing ligand having two carboxyl groups may be, for example, 2,2'-bipyridine-4,4'-dicarboxylic acid, 1,10-phenanthroline-4,'7-dicarboxylic acid, 2-(2-(4-carboxypyridyl))-4-carboxyquinoline, or 2,2'-biquinoline-4,4'-dicarboxylic acid. The bidentate nitrogen-containing ligand having two carboxyl groups may be preferably 2,2'-bipyridine-4,4'-dicarbaxylic acid. In these ligands, a carboxyl group (-COOH) may be deprotonated to be a carboxyl ion (-COO⁻).

And,

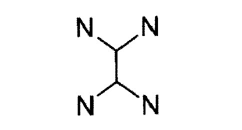

represents a tetradentate nitrogen-containing ligand.

The tetradentate nitrogen-containing ligand may be, for example, a ligand represented by the following formula (1-B1):

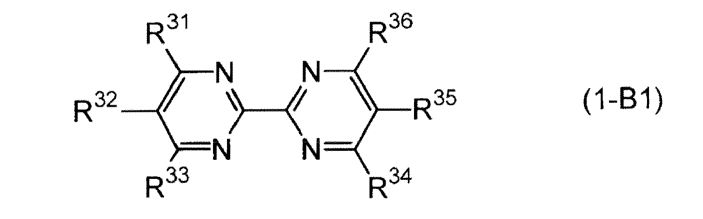

In the formula (1-B1). R³¹, R³² and R³³ each independently represents hydrogen, or a substituted or unsubstituted linear or branched alkyl group, or alternatively, two or more of R³¹ to R³³ form a substituted or unsubstituted aromatic hydrocarbon ring together with the carbon atoms to which they are bound; and R³⁴, R³⁵ and R³⁶ each independently represents hydrogen, or a substituted or unsubstituted linear or branched alkyl group, or alternatively, two or more of R³⁴ to R³⁶ form a substituted or unsubstituted aromatic hydrocarbon ring together with the carbon atoms to which they are bound.

The alkyl group may preferably have up to 6 carbon atoms. The alkyl group may be more preferably methyl or ethyl.

It is also preferred that any adjacent two of R³¹ to R³⁶ form a six-membered aromatic hydrocarbon ring, which may optionally have a substituent, together with the carbon atoms to which they are bound. Examples of the substituent on the aromatic hydrocarbon ring include alkyl groups such as methyl and ethyl, and alkoxy groups such as methoxy and ethoxy.

It is particularly preferred that R³¹ to R³⁶ each independently represents hydrogen or methyl. It is further preferred that R³¹ to R³⁶ are all hydrogen.

In addition, the tetradentate nitrogen-containing ligand may be, for example, a ligand represented by the following formula (1-B2) :

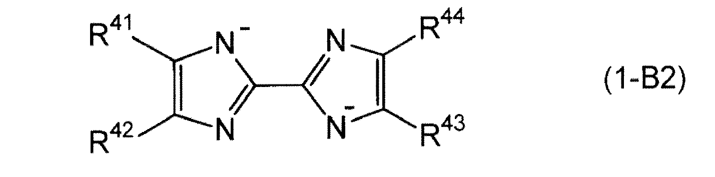

In the formula (1-B2), R⁴¹ and R¹² each independently represents hydrogen, or a substituted or unsubstituted linear or branched alkyl group, or alternatively, R⁴¹ and R⁴² form a substituted or unsubstituted aromatic hydrocarbon ring together with the carbon atoms to which they are bound; and R⁴³ and R⁴⁴ each independently represents hydrogen, or a substituted or unsubstituted linear or branched alkyl group, or alternatively, R⁴³ and R⁴⁴ form a substituted or unsubstituted aromatic hydrocarbon ring together with the carbon atoms to which they are bound.

The alkyl group may preferably have up to 6 carbon atoms. The alkyl group may be more preferably methyl or ethyl.

It is also preferred that R⁴¹ and R⁴², and/or R⁴³ and R⁴⁴ form a six-membered aromatic hydrocarbon ring, which may optionally have a substituent, together with the carbon atoms to which they are bound. Examples of the substituent on the aromatic hydrocarbon ring include alkyl groups such as methyl and ethyl, and alkoxy groups such as methoxy and methoxy.

It is particularly preferred that R⁴¹ to R⁴⁴ each independently represents hydrogen or methyl. It is further preferred that R⁴¹ to R⁴⁴ are all hydrogen. It is also particularly preferred that R⁴¹ and R⁴², and R⁴³ and R⁴⁴ form a six-membered aromatic hydrocarbon ring, which may optionally have a substituent such as methyl, together with the carbon atoms to which they are bound. The tetradentate nitrogen-containing ligand may be preferably, for example, a ligand represented by the following formula (1-B3):

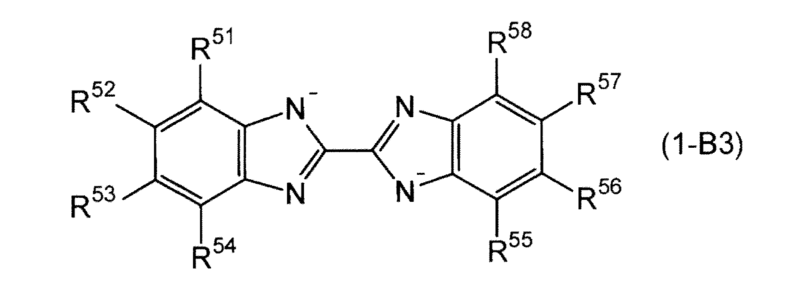

In the formula (1-B3), R⁵¹, R⁵², R⁵³ and R⁵⁴ each independently represents hydrogen, or a substituted or unsubstituted linear or branched alkyl group; and R⁵⁵, R⁵⁶, R⁵⁷ and R⁵⁸ each independently represents hydrogen, or a substituted or unsubstituted linear or branched alkyl group.

The alkyl group may preferably have up to 6 carbon atoms. The alkyl group may be more preferably methyl or ethyl.

It is preferred that R⁵¹ to R⁵⁸ each independently represents hydrogen or methyl. It is particularly preferred that R⁵¹ to R⁵⁸ are all hydrogen. It is also particularly preferred that R⁵², R⁵³ R⁵⁶ and R⁵⁷ are methyl, and R⁵¹, R⁵⁴, R⁵⁵ and R⁵⁸ are hydrogen. It is further preferred that R⁵¹ to R⁵⁸ are all hydrogen.

The tetradentate nitrogen-containing ligand may be, for example, 2,2'-bipyrimidine, 2,2'-biimidazole, or 2,2'-bibenzimidazole. The tetradentate nitrogen-containing ligand may be preferably 2,2'-biimidazole or 2,2'-bibenzimidazole, more preferably 2,2'-bibenzimidazole.

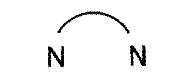

represents a bidentate nitrogen-containing ligand. The complex contains two bidentate nitrogen-containing ligands. These two ligands may be the same, or may be different from each other.

The bidentate nitrogen-containing ligand may be, for example, a ligand represented by the following formula (1-C):

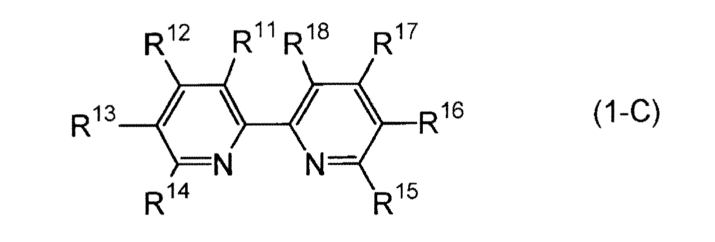

In the formula (1-C), R¹¹, R¹², R¹⁸, R¹⁴, R¹⁵, R¹⁶, R¹⁷ and R¹⁸ each independently represents hydrogen, or a substituted or unsubstituted linear or branched alkyl group, or alternatively, two or more of R¹¹ to R¹⁸ form a substituted or unsubstituted aromatic hydrocarbon ring together with the carbon atoms to which they are bound.

The alkyl group may preferably have up to 18 carbon atoms. The alkyl group may be more preferably methyl, t-butyl, nonyl or dodecyl.

It is also preferred that any adjacent two of R¹¹ to R¹⁸, and/or R¹¹ and R¹⁸ form a six-membered aromatic hydrocarbon ring, which may optionally have a substituent, together with the carbon atoms to which they are bound. Examples of the substituent on the aromatic hydrocarbon ring include alkyl groups such as methyl, t-butyl and dodecyl, and alkoxy groups such as methoxy and ethoxy.

It is particularly preferred that R¹¹ to R¹⁸ each independently represents hydrogen, methyl, t-butyl, nonyl or dodecyl. It is further preferred that R¹¹to R¹⁸ are all hydrogen. It is also further preferred that R¹² and R¹⁷ are independently methyl, t-butyl, nonyl or dodecyl, and R¹¹, R¹³ to R¹⁶ and R¹⁸ are hydrogen. In addition, it is also particularly preferred that R¹¹ and R¹⁸ form a six-membered aromatic hydrocarbon ring, which may optionally have a substituent such as methyl, together with the carbon atoms to which they are bound, and R¹² to R¹⁷ are independently hydrogen, methyl, t-butyl, nonyl or dodecyl, more preferably hydrogen. It is also particularly preferred that R¹³ and R¹⁴, and R¹⁵ and R¹⁶ form a six-membered aromatic hydrocarbon ring, which may optionally have a substituent such as methyl, together with the carbon atoms to which they are bound, and R¹¹, R¹², R¹⁷ and R¹⁸ are independently hydrogen, methyl, t-butyl, nonyl or dodecyl, more preferably hydrogen.

The bidentate nitrogen -containing ligand may be, for example, 2,2'-bipyridine, 2,2'-4,4'-dimethyl-bipyridine, 2,2'-4,4'-di-t-butyl-bipyridine, 2,2'-4,4'-dinonyl-bipyridine, 2,2'-4,4'-didodecyl-bipyridine, 1,10-phenanthroline, 2-(2-pyridinyl)quinoline, or 2,2'-biquinoline. The bidentate nitrogen-containing ligand may be preferably 2,2'-bipyridine, 2,2'-4,4'-dimethyl-bipyridine, 2,2'-4,4'-di-t-butyl-bipyridine, 2,2'-4,4'-dinonyl-bipyridine, 2,2'-4,4'-didodecyl-bipyridine or 1,10-phenanthraline.

In addition, n represents the valence of the cation, and is generally an integer of from 0 to 2, preferably 1 or 2, more preferably 1. Meanwhile, p represents a number of the counter ions needed to neutralize a charge of the complex, and

Specific examples of the binuclear metal complex to be used in the present invention, which is described above, include compounds represented by the following formulae (D-1) to (D-18). Among them, compounds represented by the following formulae (D-4), (D-5), (D-9), (D-10), (D-11), (D-13), (D-16), (D-17) and (D-18) may be suitably used. In the formulae (D-1) to (D-18), proton(s) (H⁺) of one or more carboxyl groups (-COOH) may dissociate.

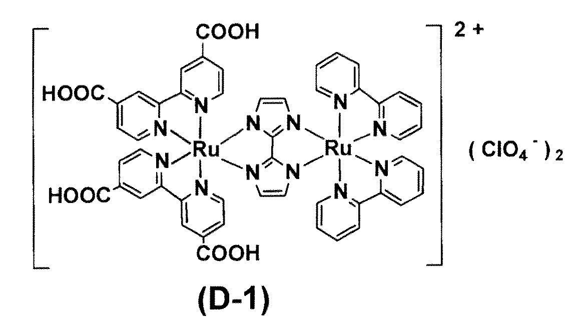

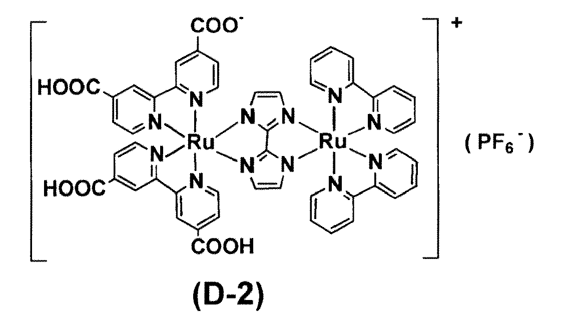

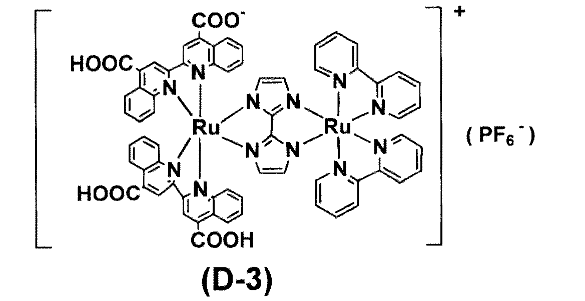

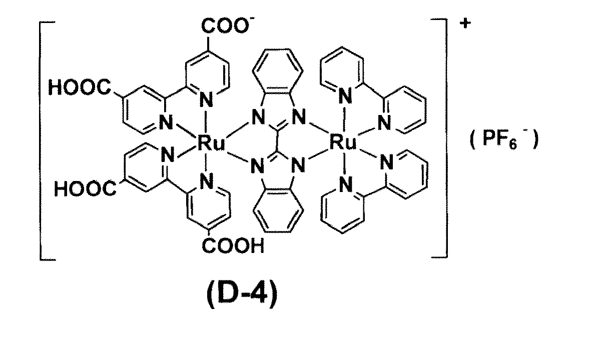

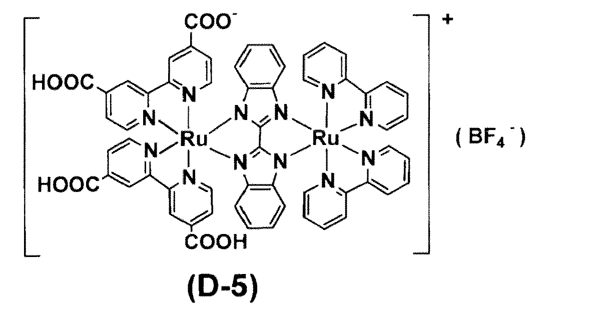

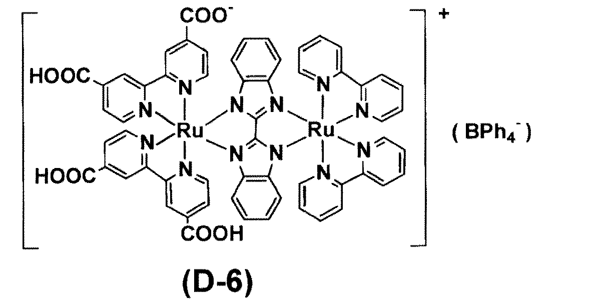

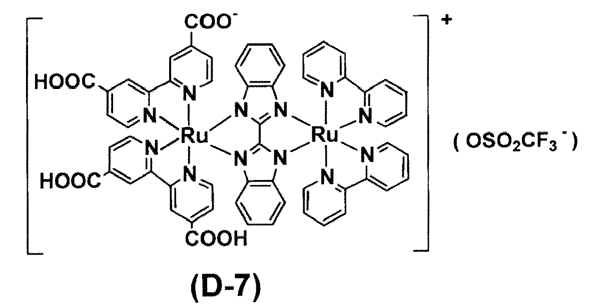

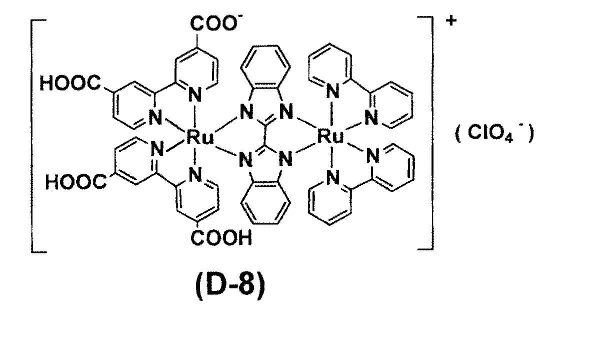

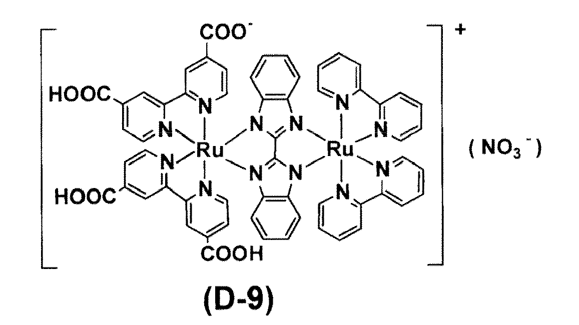

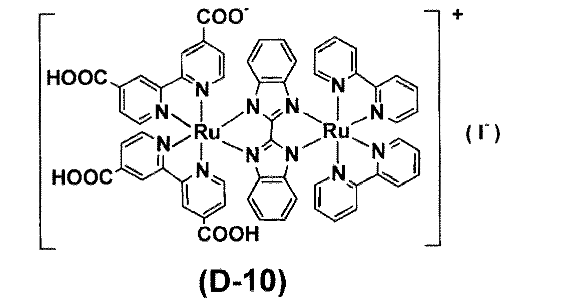

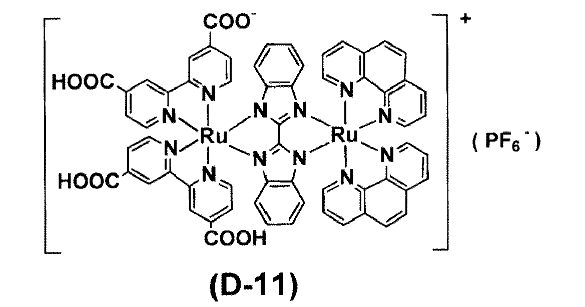

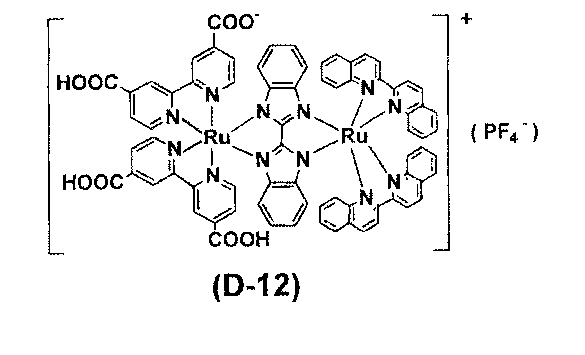

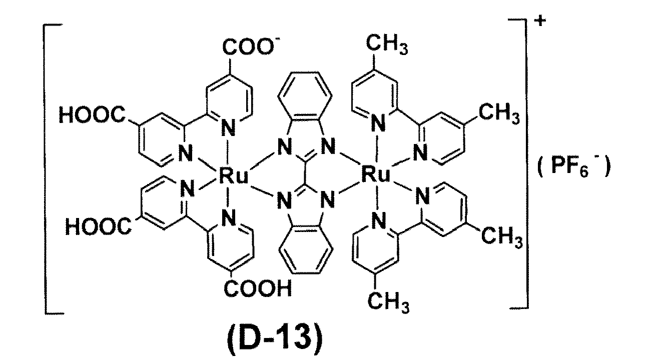

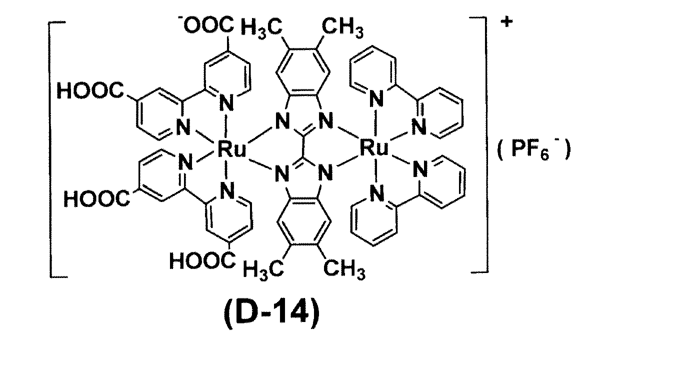

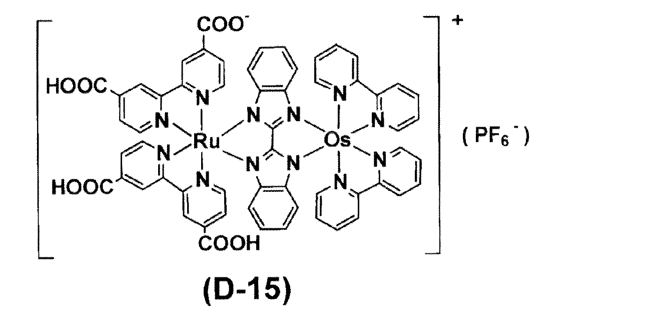

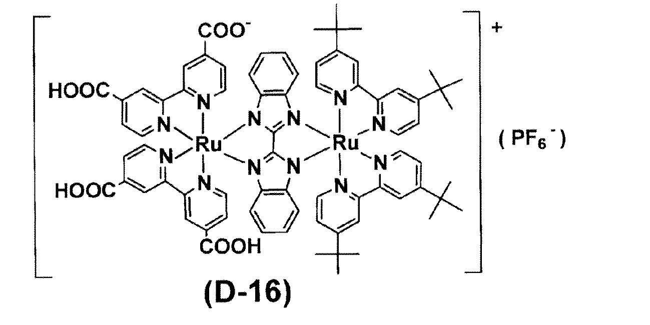

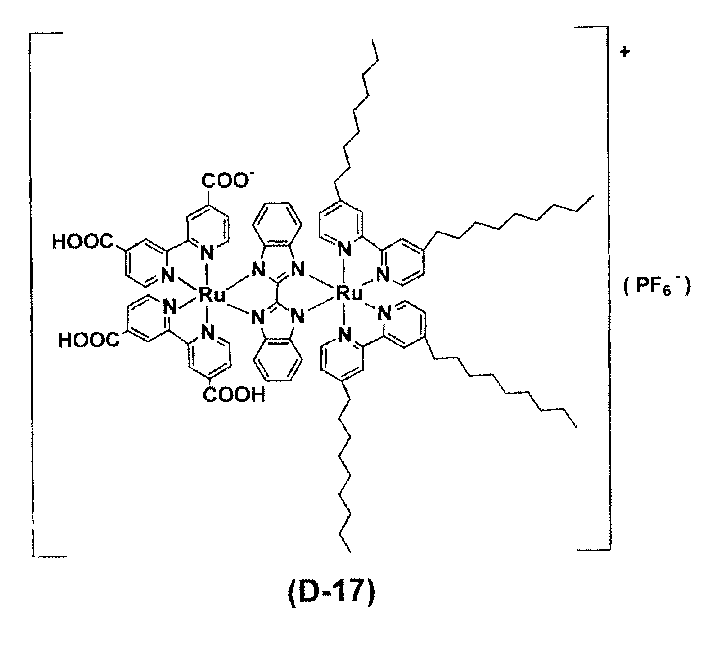

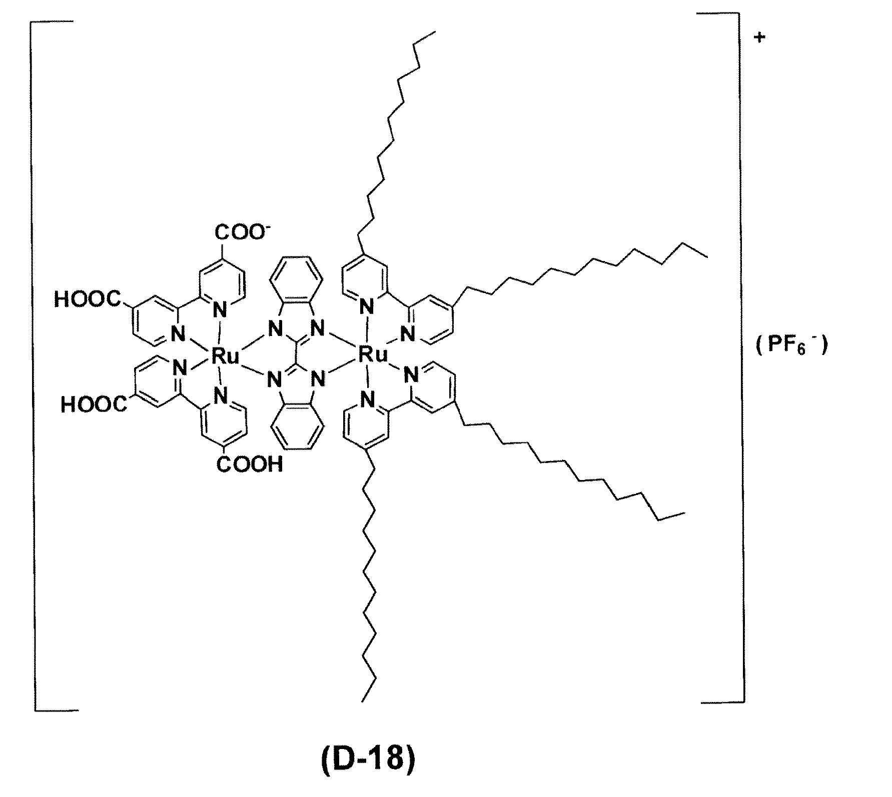

The binuclear ruthenium complex and/or the ruthenium-osmium complex may be used alone or in combination of two or more thereof.

The binuclear ruthenium complex and the ruthenium-osmium complex may be synthesized according to any known method. See WO2006/038587, for example.

Examples of the semiconductor particle to be used in the present invention include metal oxides such as titanium oxide, zinc oxide, tin oxide, indium oxide, niobium oxide, tungsten oxide and vanadium oxide; composite oxides such as strontium titanate, calcium titanate, barium titanate and potassium niobate; metal sulfides such as cadmium sulfide and bismuth sulfide; metal selenides such as cadmium selenide; metal tellurides such as cadmium telluride; metal phosphides such as gallium phosphide: and metal arsenides such as gallium arsenide. The semiconductor particle may be preferably a metal oxide, more preferably titanium oxide, zinc oxide or tin oxide. A primary particle size of the semiconductor particle may be preferably, but not limited to, from 1 nm to 5,000 nm, more preferably from 2 nm to 500 nm, particularly preferably from 3 nm to 300 nm. The semiconductor particle may be used alone or in combination of two or more thereof.

The semiconductor particle sensitized with the binuclear metal complex dye may be prepared, for example, by bringing a semiconductor particle into contact with a solution of the binuclear metal complex dye, which is prepared by dissolving the dye in a solvent, e.g., by application of the dye solution or immersion in the dye solution. See WO2006/038587, for example. After bringing a semiconductor particle into contact with the dye solution, the semiconductor particle may be desirably washed with a solvent and dried.

The photoelectric conversion element of the present invention comprises a semiconductor particle sensitized with a binuclear ruthenium complex dye and/or a ruthenium-osmium complex dye. More specifically, the photoelectric conversion element comprises a semiconductor particle sensitized with a ruthenium complex dye and/or a ruthenium-osmium complex dye, which is fixed on an electrode.

The electrode may be a conductive electrode, preferably a transparent electrode which is formed on a transparent substrate. Examples of the conducting agent include metals such as gold, silver, copper, platinum and palladium; indium oxide-based compounds, typified by tin-doped indium oxide (ITO); tin oxide-based compounds, typified by fluorine-doped tin oxide (FTO); and zinc oxide-based compounds.

A semiconductor particle sensitized with a binuclear ruthenium complex dye and/or a ruthenium-osmium complex dye, as described above, may be used to produce a photochemical cell of the present invention.

More specifically, the photochemical cell of the present invention comprises a photoelectric conversion element of the present invention as described above, and a counter electrode as electrodes; and comprises a layer of an electrolyte solution between the electrodes. At least one of the electrode used in the photoelectric conversion element of the present invention and the counter electrode is a transparent electrode.

The counter electrode functions as a cathode when it is combined with the photoelectric conversion element to form a photochemical cell. Although a substrate on which a conductive layer is formed may be used as a counter electrode, like the conductive electrode as described above, a substrate is not necessarily required for a counter electrode, for example, a metal plate itself may be used as a counter electrode. Preferable examples of the conducting agent to be used for the counter electrode include metals such as platinum; carbon; and conductive metal oxides such as fluorine-doped tin oxide.

According to the present invention, an electrolyte solution comprising an ionic liquid as the major component is used as an electrolyte for a photochemical cell. The electrolyte solution may comprise only an ionic liquid, for example. Alternatively, the electrolyte solution may comprise an ionic liquid and a redox couple.

The ionic liquid to be used in the present invention contains (CN)₄B⁻ as an anion component. The ionic liquid preferably contains imidazolium cation as a cation component and (CN)₄B⁻ as an anion component. The term "imidazolium cation" as used herein means a cation having an imidazolium skeleton, including imidazolium derivatives. The ionic liquid may be used alone or in combination of two or more thereof.

A preferable cation component of the ionic liquid to be used in the present invention may be represented by the following general formula (2-D1). A preferable anion component of the ionic liquid to be used in the present invention may be represented by the following general formula (2-E2).

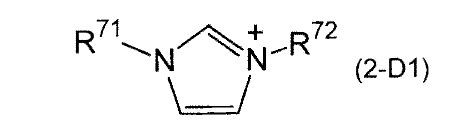

wherein R⁷¹ and R⁷² each independently represents a linear or branched alkyl group having 1 to 6 carbon atoms.

(CN)₄B⁻ (2-E2)

In the general formula (2-D1), R⁷¹ and R⁷² may be preferably an alkyl group having 1 to 3 carbon atoms, more preferably methyl or ethyl.

The ionic liquid to be used in the present invention may be preferably represented by the following general formula (2), more preferably the following general formula (2-1).

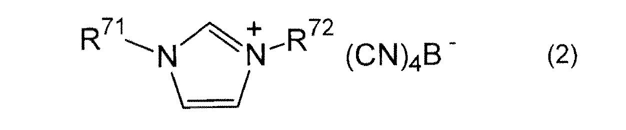

wherein R⁷¹ and R⁷² each independently represents a linear or branched alkyl group having 1 to 6 carbon atoms.

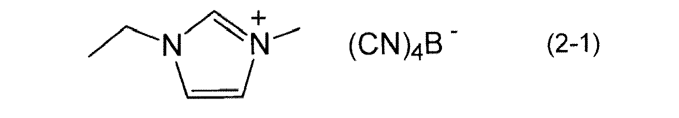

The compound represented by the formula (2-1) is 1-ethyl-3-methyl imidazolium tetracyanoborate.

The electrolyte solution to be used in the present invention may preferably comprise a redox couple. Examples of the redox couple to be used include, but not limited to,
(1) combination of iodine and an iodide (e.g., iodides of metals such as lithium iodide and potassium iodide, and iodides of quaternary ammonium compounds such as tetrabutylammonium iodide, tetrapropylammonium iodide, pyridinium iodide and imidazolium iodide);
(2) combination of bromine and a bromide (e.g., bromides of metals such as lithium bromide and potassium bromide, and bromides of quaternary ammonium compounds such as tetrabutylammonium bromide, tetrapropylammonium bromide, pyridinium bromide and imidazolium bromides);
(3) combination of chlorine and a chloride (e.g., chlorides of metals such as lithium chloride and potassium chloride, and chlorides of quaternary ammonium compounds such as tetrabutylammonium chloride, tetrapropylammonium chloride, pyridinium chloride and imidazolium chloride);
(4) combination of an alkylviologen and a reduced form thereof;
(5) quinone/hydroquinone; transition metal ion pair such as iron (II) ion/iron (III) ion, copper (I) ion/copper (II) ion, manganese (II) ion/manganese (III) ion, and cobalt (II) ion/cobalt (III) ion;
(6) combination of complex ions such as ferrocyanide/ferricyanide, cobalt (II) tetrachloride/cobalt (III) tetrachloride, cobalt (II) tetrabromide/cobalt (III) tetrabromide, iridium(II) hexachloride/iridium (III) hexachloride, ruthenium (II) hexacyanide/ruthenium (III) hexacyanide, rhodium (II) hexachloride/rhodium (III) hexachloride, rhenium (III) hexachloride/rhenium (IV) hexachloride, rhenium (IV) hexachloride/rhenium (V) hexachloride, osmium (III) hexachloride/osmium (IV) hexachloride, and osmium (IV) hexachloride/osmium (V) hexachloride;
(7) complexes formed with a transition metals such as cobalt, iron, ruthenium, manganese, nickel and rhenium, and a conjugated heterocyclic ring and derivative thereof such as bipyridine and derivative thereof, terpyridine and derivative thereof, and phenanthroline and derivative thereof;
(8) complexes of cyclopentadiene or derivative thereof and a metal such as ferrocene/ferrocenium ion, cobaltocene/cobaltocenium ion, and ruthenocene/ruthenocenium ion; and
(9) porphyrin compounds.
The redox couple listed in the above-mentioned section (1) may be suitably used. The redox couple may be used alone or in combination of two or more thereof. The amount of the redox couple to be used may be appropriately selected.

The photochemical cell of the present invention may be produced by any conventional process. For example, the photochemical cell of the present invention may be produced by
(1) applying a paste of semiconductor particle such as an oxide onto a transparent electrode, and then calcining the paste, to form a semiconductor particle film;
(2) calcining the paste at a temperature of 400 °C to 550 °C for 0.5 hr to 1 hr, for example, in the case where the semiconductor particle film is titania;
(3) immersing the transparent electrode with the semiconductor particle film thus obtained in a solution of a binuclear metal complex dye, to produce a dye-supported photoelectric conversion element; and
(4) combining the photoelectric conversion element thus obtained with a counter electrode, i.e. a transparent electrode on which platinum or carbon is vapor-deposited, and placing an electrolyte solution between them.

### EXAMPLES

The present invention will be more specifically described with reference to the following Examples. However, the scope of the present invention is not limited to the Examples. The binuclear ruthenium complex dyes used in Examples were synthesized by reference to WO2006/038587.

### Example 1

### <Production of a porous titania electrode>

A titania paste PST-18NH for a transparent layer and a titania paste PST-400C for a diffusion layer, both of which were made by Catalysts & Chemicals Industries Co., Ltd., were applied onto a transparent conductive glass electrode, which was made by Asahi Glass Co., Ltd., using a screen printer. The film thus obtained was aged in an atmosphere at 25 °C and 60 %RH for 5 minutes, and then the aged film was calcined at 440 to 460 °C. for 30 minutes. The same procedure was repeated to produce a 16 mm² porous titania electrode.

### <Production of a dye-adsorbed porous titania electrode>

A saturated solution of the binuclear ruthenium complex dye (D-4) was prepared by adding the dye to a mixed solvent of t-butanol / acetonitrile [=1:1 (volume ratio)]. And then, the porous titania electrode was immersed in the saturated dye solution in a thermal chamber at 30 °C (internal temperature) for 20 hours, to produce a dye-adsorbed porous titania electrode.

### <Production of a photochemical cell>

A hole was formed through a platinum counter electrode, using a diamond drill. And then, the dye-adsorbed porous titania electrode was placed on the platinum counter electrode such that the dye-adsorbed porous titania layer was located between the transparent conductive glass electrode of the dye-adsorbed porous titania electrode and the counter electrode. Subsequently, a hot-melt sealant was placed around the dye-adsorbed porous titania layer between the electrodes, and then the laminate was heated to bond the titania electrode to the counter electrode. Meanwhile, a solution having an iodide ion concentration of 1.0 mol/L was prepared from 1-ethyl-3-methyl imidazolium tetracyanoborate (ionic liquid) and 1-ethyl-3-methyl imidazolium iodide and iodine (redox couple), and then t-butylpyridine was added to the solution in an amount of 0.5 mol/L, to provide an electrolyte solution. And then, the electrolyte solution was poured into a gap between the titania electrode and the counter electrode through the through-hole in the platinum counter electrode. Subsequently, a hot-melt sealant and a glass plate were placed on the through-hole in that order, and then the laminate was heated again, to close the through-hole and produce a photochemical cell.

### <Durability test>

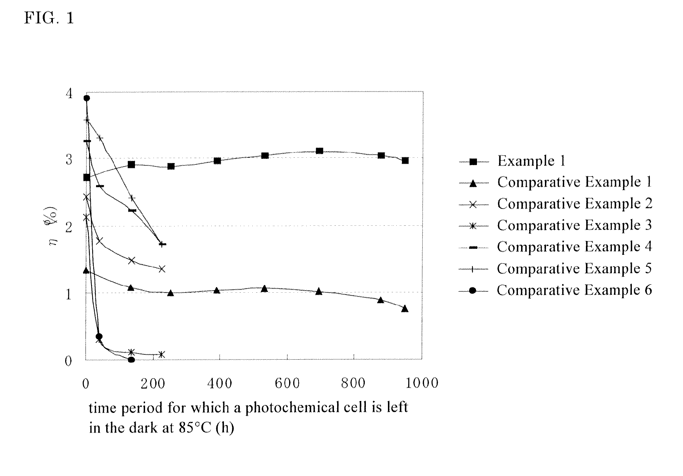

The photochemical cell thus obtained was left in the dark at 85 °C. for the predetermined time period, and then returned to room temperature. Subsequently, the photoelectric conversion efficiency (η) of the photochemical cell was measured under irradiation with artificial solar light at 100 mW/cm², using a solar simulator made by EKO Instruments Co., Ltd. FIG. 1 shows the change in the photoelectric conversion efficiency of the photochemical cell with respect to the time period for which the photochemical cell was left in the dark at 85 °C.

### Comparative Examples 1 to 6

Photochemical cells were produced in the same way as in Example 1, except that the following compounds were used as the ionic liquid. The durability tests were conducted in the same way as in Example 1 on the photochemical cells thus obtained, and the results are shown in FIG. 1.

(Ionic liquids used in Example 1 and Comparative Examples 1 to 6)
Example 1: 1-ethyl-3-methyl imidazolium tetracyanoborate
Comparative Example 1: 1-ethyl-3-methyl imidazolium bis(trifluoromethyl sulfonyl) imide
Comparative Example 2: 1-ethyl-3-methyl imidazolium trifluoromethane sulfonate
Comparative Example 3: 1-ethyl-3-methyl imidazolium p-toluene sulfonate
Comparative Example 4: 1-ethyl-3-methyl imidazolium ethyl sulfate
Comparative Example 5: 1-ethyl-3-methyl imidazolium 2-(2-methoxy ethoxy)ethyl sulfate
Comparative Example 6: 1-ethyl-3-methyl imidazolium dicyanamide

### Example 2

### <Production of a porous titania electrode>

A porous titania electrode was produced in the same way as in Example 1.

### <Production of a dye-adsorbed porous titania electrode>

A 0.3 mmol/L solution of the binuclear ruthenium complex dye (D-17) was prepared by adding the dye to a mixed solvent of t-butanal / acetonitrile [=1:1 (volume ratio)]. And then, the porous titania electrode was immersed in the dye solution in a thermal chamber at 30 °C. (internal temperature) for 5 hours, to produce a dye-adsorbed porous titania electrode.

### <Production of a photochemical cell>

A hole was formed through a platinum counter electrode, using a diamond drill. And then, the dye-adsorbed porous titania electrode was placed on the platinum counter electrode such that the dye-adsorbed porous titania layer was located between the transparent conductive glass electrode of the dye-adsorbed porous titania electrode and the counter electrode. Subsequently, a hot-melt sealant was placed around the dye-adsorbed porous titania layer between the electrodes, and then the laminate was heated to bond the titania electrode to the counter electrode. Meanwhile, a solution having an iodide ion concentration of 0.6 mol/L was prepared from 1-ethyl-3-methyl imidazolium tetracyanoborate (ionic liquid) and 1-propyl-3-methyl imidazolium iodide and iodine (redox couple), and then t-butylpyridine was added to the solution in an amount of 0.5 mol/L, to provide an electrolyte solution. And then, the electrolyte solution was poured into a gap between the titania electrode and the counter electrode through the through-hole in the platinum counter electrode. Subsequently, a hot-melt sealant and a glass plate were placed on the through-hole in that order, and then the laminate was heated again, to close the through-hole and produce a photochemical cell.

### <Durability test>

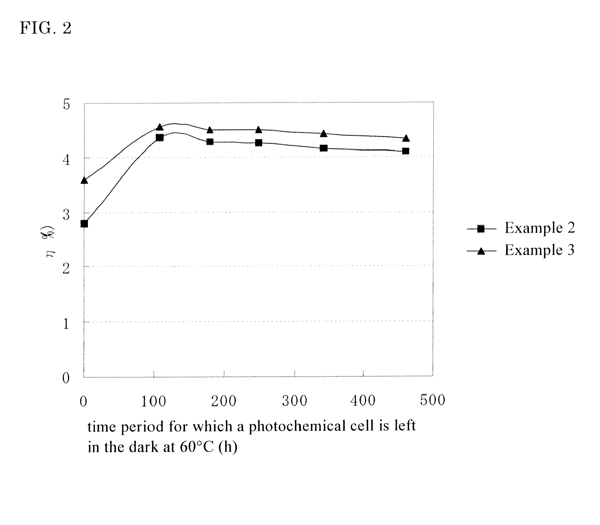

The photochemical cell thus obtained was left in the dark at 60 °C. for the predetermined time period, and then returned to room temperature. Subsequently, the photoelectric conversion efficiency (η) of the photochemical cell was measured under irradiation with artificial solar light at 100 mW/cm², using a solar simulator made by EKO Instruments Co., Ltd. FIG. 2 shows the change in the photoelectric conversion efficiency of the photochemical cell with respect to the time period for which the photochemical cell was left in the dark at 60 °C.

### Example 3

A photochemical cell was produced in the same way as in Example 2, except that the binuclear ruthenium complex dye (D-18) was used, instead of the binuclear ruthenium complex dye (D-17). The durability tests were conducted in the same way as in Example 2 on the photochemical cell thus obtained. FIG. 2 shows the change in the photoelectric conversion efficiency of the photochemical cell with respect to the time period for which the photochemical cell was left in the dark at 60 °C.

As seen from the results given in FIGs. 1 and 2, the photochemical cells of the present invention, which comprised semiconductor particles sensitized with specific binuclear metal complex dyes and specific ionic liquids, exhibited high photoelectric conversion efficiency and had good durability.

### Industrial Applicability

According to the present invention, there may be provided a photochemical cell having high photoelectric conversion efficiency and good durability, which comprises a semiconductor particle sensitized with a binuclear metal complex dye having a high absorption coefficient and an excellent electron transfer property, and an electrolyte solution comprising an ionic liquid as the major component. It is expected that the photochemical cell will be suitable for practical use.

## Claims

1. A photochemical cell, comprising:
a semiconductor particle sensitized with a binuclear metal complex dye, which is represented by the following general formula (1): 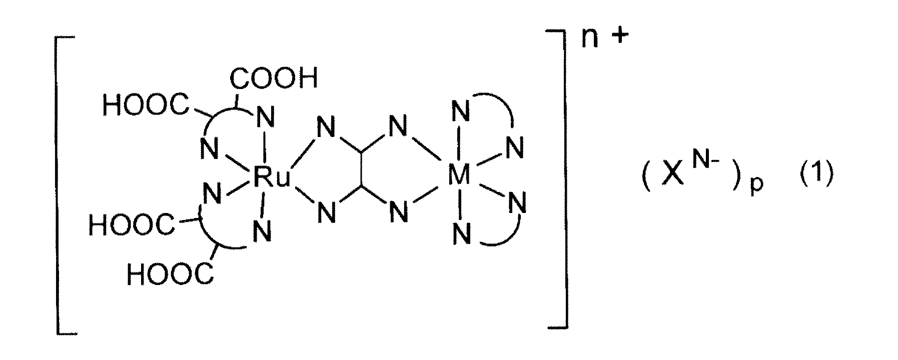 wherein
M represents Ru or Os,
X^{N-} represents an N-valent anion as a counter ion, wherein N is 1 or 2, 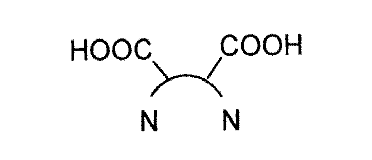 represents a bidentate nitrogen-containing ligand having two carboxyl groups, 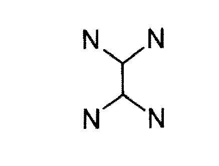 represents a tetradentate nitrogen-containing ligand, 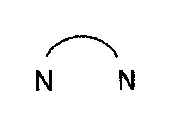 represents a bidentate nitragen-containing ligand,
n represents an integer of from 0 to 2,
p represents a number of the counter ions needed to neutralize a charge of the complex, and
one or more carboxyl groups (-COOH) may be deprotonated to be a carboxyl ion (-COO⁻); and
an electrolyte solution which comprises an ionic liquid containing (CN)₄B⁻ as an anion component, wherein the ionic liquid is the major component of the electrolyte solution.

2. A photochemical cell according to Claim 1, wherein X^{N-} is hexafluorophosphate ion, tetrafluoroborate ion, nitrate ion or iodide ion.

3. A photochemical cell according to Claim 1, wherein the bidentate nitrogen-containing ligand is 2,2'-bipyridine, 2,2'-(4,4'-dimethyl)bipyridine, 2,2'-(4,4'-di-t-butyl)bipyridine, 2,2'-(4,4'-di-n-nonyl)bipyridine, 2,2'-(4,4'-di-n-dodecyl)bipyridine or 1,10-phenanthroline.

4. A photochemical cell according to Claim 1, wherein the bidentate nitrogen-containing ligand having two carboxyl groups is 2,2'-bipyridine-4,4'-dicarboxylic acid.

5. A photochemical cell according to Claim 1, wherein the tetradentate nitrogen-containing ligand is 2,2'-biimidazole or 2,2'-bibenzimidazole.

6. A photochemical cell according to Claim 1, wherein the ionic liquid contains imidazolium cation as a cation component.

7. A photochemical cell according to Claim 1, wherein the ionic liquid is represented by the following general formula (2): 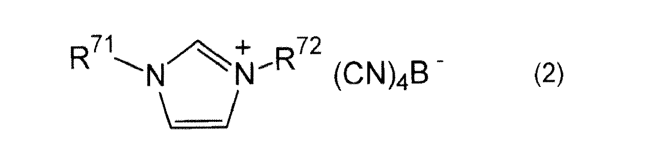 wherein R⁷¹ and R⁷² each independently represents a linear or branched alkyl group having 1 to 6 carbon atoms.

8. A photochemical cell according to Claim 1, wherein the electrolyte solution comprises a redox couple.

9. A photochemical cell according to Claim 1, wherein the semiconductor particle is titanium oxide, zinc oxide, tin oxide, or a mixture thereof.

10. A photochemical cell according to Claim 1, wherein the photochemical cell comprises a photoelectric conversion element in which the semiconductor particle sensitized with the binuclear metal complex dye is fixed on an electrode; a counter electrode; and a layer of the electrolyte solution comprising the ionic liquid as the major component, which is placed between the photoelectric conversion element and the counter electrode.
